# DEMANDE DE BREVET EUROPEEN

(11) **EP 4 576 980 A1**
(43) Date de publication de la demande: **25.06.2025**
(21) Numéro de dépôt: 24222244.6
(22) Date de dépôt: 20.12.2024
(51) Int. Cl.: H10B 53/30, H10B 51/30

(54) **DISPOSITIF DE STOCKAGE FERROELECTRIQUE ET PROCEDE DE FABRICATION D'UN TEL DISPOSITIF**

(30) Priorité: 21.12.2023 FR 2314880
(71) Demandeur: Commissariat à l'Energie Atomique et aux Energies Alternatives, 75015 Paris (FR)
(72) Inventeur: BORREL, Julien, 38054 GRENOBLE CEDEX (FR); BARBOT, Justine, 38054 GRENOBLE CEDEX 09 (FR); COIGNUS, Jean, 38054 GRENOBLE CEDEX 09 (FR); GRENOUILLET, Laurent, 38054 GRENOBLE CEDEX 09 (FR)
(74) Mandataire: Cabinet Camus Lebkiri

(57) **Abrégé**

L'invention concerne un procédé de fabrication d'un dispositif (1) de stockage ferroélectrique comprenant :
- dépôt d'une première couche (2),
- dépôt d'une première couche de matériau ferroélectrique,
- dépôt d'une couche intermédiaire sur la première couche de matériau ferroélectrique,
- retrait d'une première partie de la couche intermédiaire de sorte à exposer une partie (6A) de la première couche de matériau ferroélectrique,
- dépôt d'une deuxième couche de matériau ferroélectrique sur la couche intermédiaire et sur la partie exposée de la première couche de matériau ferroélectrique,
- retrait d'une deuxième partie de la couche intermédiaire de manière à former une couche de matériau ferroélectrique (5) comprenant une première partie (5A) de première épaisseur (e₁) et une deuxième partie (6) de deuxième épaisseur (e₂), les première et deuxième épaisseurs étant distinctes,
- dépôt d'une deuxième couche (7), la couche de matériau ferroélectrique s'étendant entre la première couche et la deuxième couche.

## Description

### DOMAINE TECHNIQUE

La présente invention concerne de manière générale le domaine de la micro-électronique. Elle concerne plus particulièrement le domaine des mémoires non volatiles.

En particulier, l'invention concerne un dispositif de stockage ferroélectrique. Elle concerne également un procédé de fabrication d'un tel dispositif de stockage ferroélectrique.

### ÉTAT DE LA TECHNIQUE

Les mémoires ferroélectriques de type FeRAM (pour « *Ferroelectric Random Access Memory* » selon l'acronyme d'origine anglo-saxonne couramment utilisé) ont pour principale qualité d'être non volatiles, c'est-à-dire de conserver l'information stockée même quand la tension est coupée. Elles présentent également les avantages de consommer peu d'énergie et d'avoir des temps d'écriture et de lecture faibles par rapport à d'autres types de mémoires non volatiles comme les mémoires FLASH.

Les mémoires ferroélectriques de type FeRAM se présentent généralement sous la forme d'un empilement dans lequel une couche de matériau ferroélectrique est positionnée entre deux électrodes métalliques. Les mémoires ferroélectriques sont des mémoires de type capacitif présentant deux états de polarisation rémanente +Pr et - Pr. Le fonctionnement de ces mémoires ferroélectriques repose sur les propriétés ferroélectriques du matériau ferroélectrique placé entre deux électrodes métalliques.

Plus particulièrement, concernant le fonctionnement des mémoires ferroélectriques de type FeRAM, par l'application d'une différence de potentiels entre les deux électrodes créant un champ électrique d'une valeur supérieure à un champ coercitif positif +Ec, la mémoire ferroélectrique est placée dans un état de polarisation rémanente haute +Pr et par l'application d'une différence de potentiels créant un champ électrique d'une valeur inférieure au champ coercitif négatif -Ec, la mémoire ferroélectrique est placée dans un état de polarisation rémanente basse -Pr.

L'état de polarisation rémanente haute +Pr correspond alors à l'état logique binaire '0' et l'état de polarisation rémanente basse -Pr à l'état logique binaire '1', ce qui permet le stockage de l'information.

Par ailleurs, lorsque l'application de la différence de potentiels entre les deux électrodes métalliques est arrêtée, l'état de polarisation rémanente demeure : ceci explique alors le caractère non volatil des mémoires ferroélectriques.

Pour la lecture, il est supposé que la mémoire est dans un état donné et une tension est appliquée. Cette tension est par exemple positive, supérieure à la tension créant un champ électrique d'une valeur supérieure au champ coercitif positif +Ec. Ainsi, si la mémoire était déjà dans l'état de polarisation rémanente haute +Pr, cet état de polarisation est inchangé et aucun pic de courant n'est observé (ou un très faible pic de courant peut être observé). A l'inverse, si la mémoire était dans l'état de polarisation rémanente basse -Pr, un pic de courant beaucoup plus important est observé.

La conséquence de cette opération de lecture est qu'elle est destructrice de l'état de polarisation.

Des mémoires ferroélectriques à jonction tunnel (ou de type FTJ pour « Ferroelectric Tunnel Junction » selon l'acronyme d'origine anglo-saxonne couramment utilisé) sont également connues. Les mémoires ferroélectriques de type FTJ se présentent généralement sous la forme d'un empilement dans lequel une couche de matériau ferroélectrique est positionnée entre deux électrodes métalliques. Les mémoires ferroélectriques de type FTJ sont des mémoires de type résistif présentant deux états de polarisation opposés pour la couche de matériau ferroélectrique. Le fonctionnement de ces mémoires ferroélectriques repose sur les propriétés ferroélectriques du matériau ferroélectrique placé entre deux électrodes métalliques.

Plus particulièrement, concernant le fonctionnement des mémoires ferroélectriques de type FTJ, les deux états de polarisation correspondent respectivement à deux niveaux de résistance différents : un niveau fortement résistif, correspondant à par exemple à un état de polarisation haute +Pr et un niveau faiblement résistif, correspondant à un état de polarisation basse -Pr. A titre d'exemple, le niveau faiblement résistif présente une résistance électrique environ mille fois inférieure à celle du niveau fortement résistif.

Dans le cas des mémoires ferroélectriques de type FTJ, l'opération de lecture comprend l'application d'une tension de lecture -Vr. La tension de lecture -Vr est par exemple négative et inférieure en valeur absolue à une tension Vc associée au champ coercitif. Cela permet alors d'effectuer une lecture non-destructive par l'intermédiaire de la mesure d'un courant tunnel.

Afin d'augmenter la densité de mémoire, il est connu de mettre en oeuvre un stockage dit « multi-niveaux ». Ce stockage « multi-niveaux » est associé à différents états de polarisation, sur lesquels il va être possible de mémoriser de l'information.

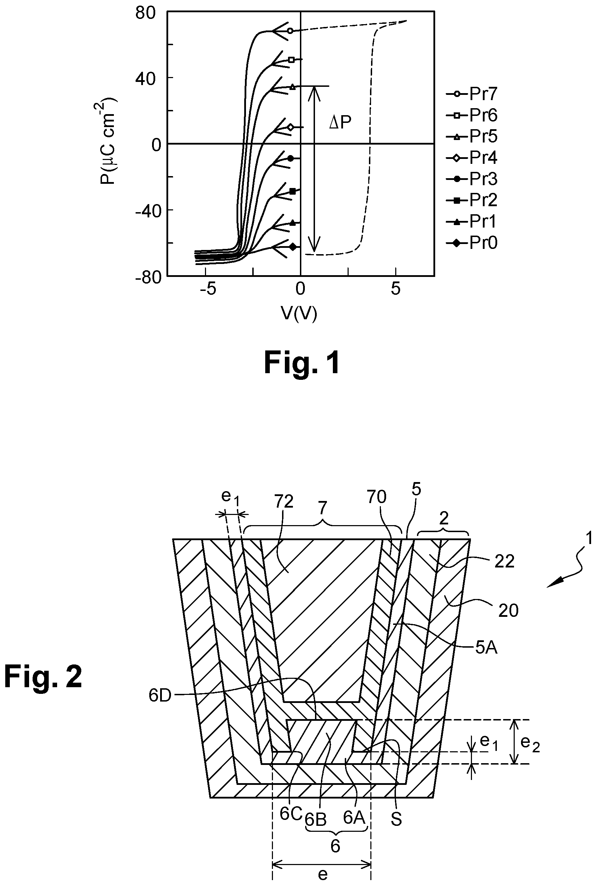

Le document « Multilevel data storage memory using deterministic polarization control. », de Lee, Daesu et al., dans Advanced materials, vol. 24(3), 2012, 402-406, doi:10.1002/adma.201103679 décrit une mémoire ferroélectrique de type FeRAM présentant plusieurs niveaux de stockage. Dans cet exemple, comme cela est représenté sur la figure 1 (représentant l'évolution de la polarisation P en fonction de la tension appliquée V), la mémoire peut être placée dans plusieurs états de polarisation rémanente intermédiaires Pr₁, Pr₂, Pr₃, Pr₄, Pr₅, Pr₆, Pr₇ (Pr₀ correspondant à l'état 0 de polarisation basse). Il va donc être possible de stocker l'information à différents niveaux. Grâce à ce stockage « multi-niveaux », il est donc possible de coder plusieurs états par mémoire (ici, dans l'exemple, huit états sont codés), alors que dans une cellule standard seulement deux états sont accessibles (les états 0 ou 1 uniquement). Ainsi, l'information contenue dans une mémoire avec un stockage « multi-niveaux » est équivalent à celle contenue dans plusieurs mémoires de type standard.

En pratique, dans cet exemple, pour mettre en oeuvre ce stockage sur les différents niveaux intermédiaires, chaque état de polarisation intermédiaire Pr₁, Pr₂, Pr₃, Pr₄, Pr₅, Pr₆, Pr₇ est associé à un courant correspondant. Ainsi, lors de l'application d'une tension entre les électrodes, un courant ferroélectrique associé est lu. Ce courant permet ensuite d'identifier l'état de polarisation intermédiaire Pr₁, Pr₂, Pr₃, Pr₄, Pr₅, Pr₆, Pr₇ concerné et donc de remonter à l'information stockée initialement dans cet état de polarisation intermédiaire Pr₁, Pr₂, Pr₃, Pr₄, Pr₅, Pr₆, Pr₇ de la mémoire ferroélectrique.

Cependant, certains inconvénients sont observés dans de telles mémoires à haute densité. Il peut par exemple être difficile de distinguer deux états de polarisation intermédiaires qui sont proches. En effet, un recouvrement entre les différents états de polarisation intermédiaires peut être rencontré. Dans un tel cas, l'application d'une tension (entre les électrodes) de cette zone de recouvrement ne permet pas de déduire de manière certaine le courant associé, et donc l'état de polarisation rémanente intermédiaire concerné.

### RÉSUMÉ DE L'INVENTION

La présente invention vise donc à améliorer les dispositifs de stockage ferroélectrique à haute densité en permettant une distinction sans ambiguïté des différents états de polarisation.

L'invention concerne alors un procédé de fabrication d'un dispositif de stockage ferroélectrique comprenant des étapes de :
- fourniture d'une couche support,
- dépôt d'une première couche,
- dépôt d'une première couche de matériau ferroélectrique, puis
- dépôt d'une couche intermédiaire sur la première couche de matériau ferroélectrique, puis
- retrait d'une première partie de la couche intermédiaire de sorte à exposer une partie de la première couche de matériau ferroélectrique, puis
- dépôt d'une deuxième couche de matériau ferroélectrique sur la couche intermédiaire et sur la partie exposée de la première couche de matériau ferroélectrique, puis
- retrait d'une deuxième partie de la couche intermédiaire de manière à former, à partir de la première couche de matériau ferroélectrique et d'une portion de la deuxième couche de matériau ferroélectrique, une couche de matériau ferroélectrique comprenant une première partie présentant une première épaisseur et une deuxième partie présentant une deuxième épaisseur, la première épaisseur et la deuxième épaisseur étant distinctes, et
- dépôt d'une deuxième couche, la couche de matériau ferroélectrique s'étendant entre la première couche et la deuxième couche.

Ainsi, d'après le procédé de fabrication conforme à l'invention, la couche de matériau ferroélectrique du dispositif de stockage ferroélectrique présente une épaisseur non uniforme. Cette variabilité d'épaisseurs entraîne une non-uniformité dans les propriétés ferroélectriques du dispositif de stockage ferroélectrique. Cette non-uniformité des propriétés permet notamment d'augmenter les différences entre les gammes de tensions à appliquer pour mémoriser les informations dans les différents états de polarisation intermédiaires.

En effet, les différentes épaisseurs impliquent alors, que pour une tension (d'écriture) donnée, le champ électrique est plus grand dans les régions de plus faible épaisseur. En d'autres termes, pour écrire des informations dans un état de polarisation intermédiaire associé à une faible épaisseur, une plus grande tension doit être appliquée. Les différences d'épaisseurs conduisent donc à des différences de tensions à appliquer pour encoder les informations dans les différents états de polarisation intermédiaires.

Les épaisseurs différentes utilisées sont donc associées à différents états de polarisation intermédiaires dans le dispositif de stockage ferroélectrique.

En d'autres termes, grâce à la non-uniformité créée dans la couche de matériau ferroélectrique (due à la variabilité d'épaisseurs), les différences entre les états de polarisation intermédiaires sont créées.

Outre les caractéristiques qui viennent d'être évoquées dans les paragraphes précédents, le procédé de fabrication du dispositif de stockage ferroélectrique selon un aspect de l'invention peut présenter une ou plusieurs caractéristiques complémentaires parmi les suivantes, considérées individuellement ou selon toutes les combinaisons techniquement possibles :
- le dépôt de la première couche de matériau ferroélectrique est mis en oeuvre de manière conforme ;
- le dépôt de la couche intermédiaire est mis en oeuvre de manière conforme ;
- la couche intermédiaire comprend un nitrure ou un oxyde ;
- l'étape de retrait de la première partie de la couche intermédiaire est mise en oeuvre par une gravure anisotrope ;
- le dépôt de la deuxième couche de matériau ferroélectrique est mis en oeuvre de manière conforme ;
- l'étape de retrait de la deuxième partie de la couche intermédiaire est mise en oeuvre par une gravure isotrope ;
- la couche de matériau ferroélectrique comprend du dioxyde d'hafnium ou du dioxyde d'hafnium dopé par un élément dopant ou un alliage HfₓZr₁₋ₓO₂, avec 0<x<1 ; et
- il est prévu, avant l'étape de dépôt de la première couche, une étape de formation d'une cavité dans la couche support, la cavité comprenant une paroi de fond et une paroi latérale, la paroi latérale formant un angle d'inclinaison par rapport à une direction normale à la paroi de fond,

le dépôt de la première couche, de la couche de matériau ferroélectrique et de la deuxième couche étant mis en oeuvre dans la cavité formée,
la deuxième partie de la couche de matériau ferroélectrique étant positionnée sur la paroi de fond de la cavité et la première partie de la couche de matériau ferroélectrique étant positionnée sur la paroi latérale de la cavité.

L'invention concerne également un dispositif de stockage ferroélectrique comprenant :
une première couche, une deuxième couche et une couche de matériau ferroélectrique qui s'étend entre la première couche et la deuxième couche, le dispositif comprenant une couche support présentant une cavité, la cavité comprenant une paroi de fond et une paroi latérale, la paroi latérale formant un angle d'inclinaison par rapport à une direction normale à la paroi de fond, la première couche, la couche de matériau ferroélectrique et la deuxième couche étant positionnées dans la cavité,
la couche de matériau ferroélectrique comprenant une première partie présentant une première épaisseur et une deuxième partie présentant une deuxième épaisseur, la première épaisseur et la deuxième épaisseur étant distinctes,
la première partie et la deuxième partie étant positionnées entre la première couche et la deuxième couche,
la deuxième partie de la couche de matériau ferroélectrique comprenant une première portion s'étendant dans le prolongement de la première partie et une deuxième portion s'étendant en saillie par rapport à la première portion de la deuxième partie de la couche de matériau ferroélectrique, la deuxième portion étant agencée de manière à ce qu'une extrémité libre de cette deuxième portion est positionnée plus près de la deuxième partie que de la première partie de la couche de matériau ferroélectrique.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
La figure 1 illustre les différents états de polarisation intermédiaires fonctionnement dans le cas d'une mémoire ferroélectrique de type FeRAM présentant plusieurs niveaux de stockage,
La figure 2 représente, sous forme schématique, un exemple d'un dispositif de stockage ferroélectrique conforme à l'invention,
La figure 3 représente, sous forme de logigramme, un exemple du procédé de fabrication du dispositif de stockage ferroélectrique de la figure 2,
La figure 4 illustre l'étape E102 du procédé de fabrication représenté sur la figure 3,
La figure 5 illustre l'étape E104 du procédé de fabrication représenté sur la figure 3,
La figure 6 illustre l'étape E106 du procédé de fabrication représenté sur la figure 3,
La figure 7 illustre l'étape E108 du procédé de fabrication représenté sur la figure 3,
La figure 8 illustre l'étape E110 du procédé de fabrication représenté sur la figure 3,
La figure 9 illustre l'étape E112 du procédé de fabrication représenté sur la figure 3,
La figure 10 illustre l'étape E114 du procédé de fabrication représenté sur la figure 3, et
La figure 11 illustre l'étape E116 du procédé de fabrication représenté sur la figure 3.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

La présente invention vise à améliorer la fabrication des dispositifs de stockage ferroélectriques. En particulier, la présente invention concerne un dispositif de stockage à haute densité dans lequel plusieurs états de polarisation sont utilisés pour mémoriser les informations. La présente invention vise alors à améliorer la définition des états de polarisation afin d'être en mesure de clairement les distinguer pour pouvoir ensuite lire l'information mémorisée et associée à chacun des états de polarisation.

La figure 2 représente un dispositif 1 de stockage ferroélectrique conforme à l'invention. Comme cela est visible sur cette figure, le dispositif 1 de stockage ferroélectrique comprend une première couche 2, une deuxième couche 7 et une couche de matériau ferroélectrique 5 qui disposée entre la première couche 2 et la deuxième couche 7.

Le dispositif 100 de stockage ferroélectrique se présente sous la forme d'un empilement de couches. La première couche 2, la couche de matériau ferroélectrique 5 et la deuxième couche 7 forment les différentes couches de cet empilement.

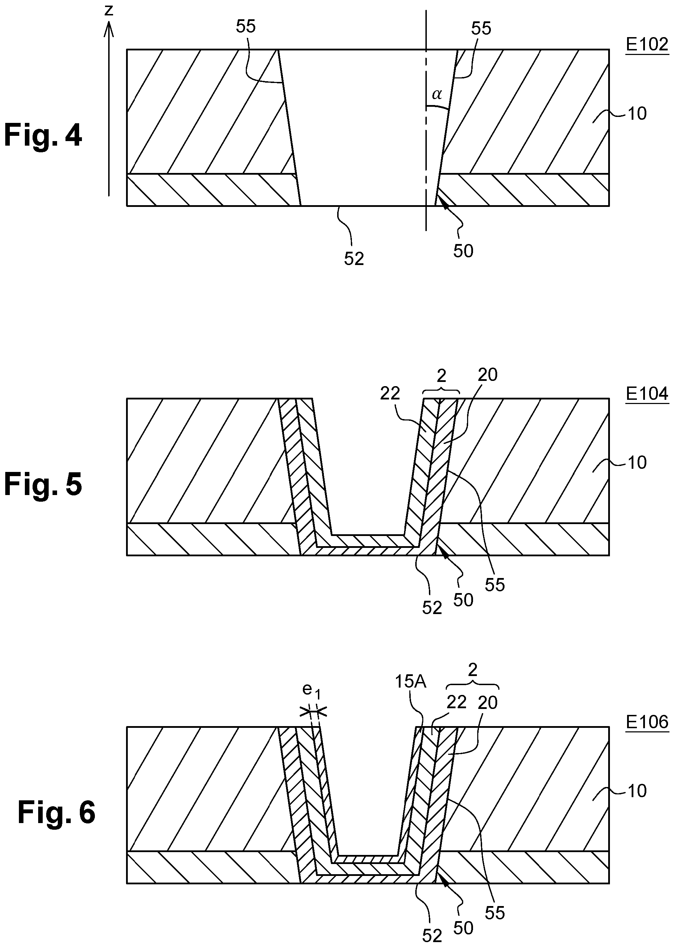

Comme cela sera décrit plus en détails par la suite avec le procédé de fabrication associé, le dispositif 1 de stockage ferroélectrique est formé dans une cavité 50 (visible sur les figures 4 à 11).

Cette cavité 50 est par exemple formée dans une couche support 10. En d'autres termes, la cavité 50 forme une partie de la couche support 10 qui présente un profil globalement en forme de « U » (comme cela sera vu par la suite, les branches latérales de la forme en « U » sont ici inclinées par rapport à la base de la forme en « U »). Ici, les différentes couches du dispositif de stockage ferroélectrique 1 présentent un profil de forme similaire à la cavité 50 avec un profil en forme de « U » de la couche support 10.

Cette couche support 10 est par exemple formée d'un matériau diélectrique. Par exemple, la couche support 10 comprend de l'oxyde de silicium SiO₂.

La couche support peut comprendre une pluralité de sous-couches. Par exemple, la couche support peut comprendre une autre couche en matériau diélectrique formée sous la couche comprenant de l'oxyde de silicium SiO₂. Cette autre couche comprend par exemple du nitrure de silicium SiN ou du carbonitrure de silicium SiCN.

La cavité 50 comprend une paroi de fond 52 et une paroi latérale 55. La paroi de fond 52 correspond à la base de la forme en « U » et la paroi latérale 55 correspond aux branches latérales de la forme en « U ». La paroi latérale 55 forme un angle d'inclinaison α par rapport à un axe z, correspondant à une direction normale à la paroi de fond 52. De préférence, cet angle d'inclinaison α est non nul. En variante, cet angle d'inclinaison peut être nul (la paroi latérale est donc verticale).

L'empilement formant le dispositif 1 de stockage ferroélectrique s'étend à partir de la paroi de fond 52 et de la paroi latérale 55. Cet empilement comprend alors plusieurs parties (une s'étendant depuis la paroi de fond 52) et une autre s'étendant depuis la paroi latérale 55. Pour la partie formée sur la paroi de fond 52, les différentes couches de l'empilement s'étendent parallèlement les unes aux autres. Il en est de même pour la partie s'étendant depuis la paroi latérale 55 (les différentes couches de l'empilement s'étendent également parallèlement les unes aux autres sur cette paroi latérale 55).

En variante, la paroi latérale de la cavité pourrait comprendre plusieurs portions formant des angles distincts par rapport à une direction normale à la paroi de fond. En d'autres termes, la paroi latérale de la cavité pourrait présenter une pluralité de ruptures de pente.

Chacune des couches formant le dispositif 1 de stockage ferroélectrique est à présent décrite.

La première couche 2 est formée d'un matériau conducteur inerte. Cette première couche 2 comprend par exemple un matériau métallique.

Selon un premier exemple (non représenté), la première couche comprend une unique couche. Le matériau conducteur de cette unique couche comprend par exemple du nitrure de titane TiN. En variante, le matériau conducteur peut être du nitrure de tantale TaN ou du tungstène W. En variante encore, d'autres matériaux conducteurs peuvent être utilisés (et en particulier, du nitrure de métal de manière plus générale).

Comme cela est visible sur l'exemple représenté sur la figure 2, la première couche 2 se présente ici sous la forme d'une structure bicouche. Elle comprend ici une première sous-couche 20 et une deuxième sous-couche 22.

La deuxième sous-couche 22 est disposée sur la première sous-couche 20.

La première sous-couche 20 comprend un matériau conducteur métallique. De préférence, elle comprend du titane Ti ou du nitrure de tantale TaN.

La première sous-couche 20 présente une épaisseur comprise entre 3 et 20 nanomètres (nm). De préférence, cette épaisseur est comprise entre 5 et 10 nm.

Cette première sous-couche 20 joue à la fois le rôle d'une couche de protection, et le rôle d'une couche de contact permettant de raccorder électriquement le dispositif 1 à son circuit électronique de pilotage et de lecture.

La deuxième sous-couche 22 est disposée sur la première sous-couche 20. Elle est en contact direct avec la couche de matériau ferroélectrique 5. En d'autres termes, la deuxième sous-couche 22 s'étend entre la première sous-couche 20 et la couche de matériau ferroélectrique 5.

La deuxième sous-couche 22 est formée d'un matériau conducteur comprenant un métal de transition. Ce matériau conducteur est par exemple du nitrure de titane TiN. En variante, il peut s'agir d'autres matériaux conducteurs tels que du tantale Ta ou du tungstène W.

Par exemple, lorsque la deuxième sous-couche 22 comprend du nitrure de titane, la première sous-couche 20 est formée d'un matériau conducteur comme le titane Ti.

En variante, lorsque la deuxième sous-couche 22 comprend du tantale, la première sous-couche 20 est formée par exemple de nitrure de tantale TaN.

En variante encore, lorsque la deuxième sous-couche 22 comprend du tungstène, la première sous-couche 20 est formée d'un matériau conducteur en titane Ti.

Ici, l'épaisseur de la deuxième sous-couche 22 est comprise entre 10 et 100 nm. De préférence, cette épaisseur est comprise entre 5 et 10 nm.

En variante, la première couche peut comprendre un matériau semi-conducteur. Ce matériau semi-conducteur comprend par exemple du silicium.

La couche de matériau ferroélectrique 5 est disposée sur la première couche 2. En variante, la couche de matériau ferroélectrique peut être déposée sur une autre couche formée, au préalable, sur la première couche.

Cette couche de matériau ferroélectrique 5 comprend un matériau actif de résistance variable. Cette couche de matériau ferroélectrique 5 est par exemple à base de dioxyde d'hafnium HfO₂. Dans la présente description, on entend par l'expression « à base de » que la couche concernée comprend plus de 50% de l'élément mentionné après cette expression (par exemple ici, cela signifie que la couche de matériau ferroélectrique 5 comprend plus de 50% de dioxyde d'hafnium).

En variante, le dioxyde d'hafnium peut être dopé par un élément dopant. Dans la présente description, l'expression « dopage » d'une couche correspond à l'introduction dans le matériau de la couche concernée des atomes d'un autre matériau appelés « élément dopant ».

Ici, l'élément dopant préférentiellement utilisé est du silicium Si. Dans le cas du silicium, la couche de matériau ferroélectrique à base de dioxyde d'hafnium est par exemple exposée à une dose de dopant comprise entre 1.10¹⁴ cm⁻² et 1.10¹⁵ cm⁻² afin d'obtenir une présence comprise entre 0,7 à 7% d'atomes de silicium dans la couche de matériau ferroélectrique. De préférence, la dose de dopant est comprise entre 0,3.10¹⁵ cm⁻² et 1.10¹⁵ cm⁻².

En variante, d'autres éléments dopants peuvent être utilisés comme de l'aluminium Al, du germanium Ge, du gadolinium Gd, de l'Yttrium Y, du lanthane La, du scandium Sc ou de l'azote N.

En variante encore, la couche de matériau ferroélectrique peut comprendre un alliage de la forme HfₓZr₁₋ₓO₂, avec 0<x<1. Par exemple, il est possible d'utiliser un alliage ternaire HfZrO₂ (par exemple du Hf_{0.5}Zr_{0.5}O₂) en tant que matériau ferroélectrique. En variante encore, la couche de matériau ferroélectrique peut être en nitrure d'aluminium scandium (AlScN).

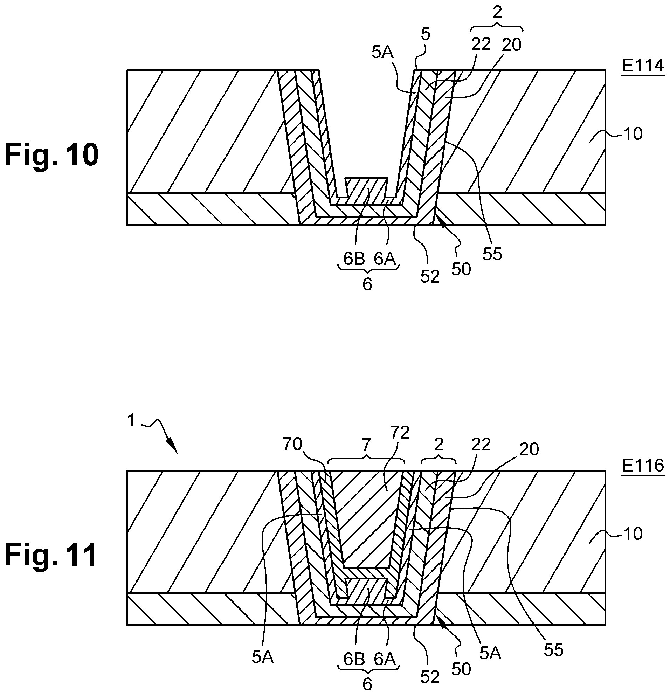

Comme cela est visible sur la figure 2, la couche de matériau ferroélectrique 5 comprend au moins une première partie 5A et une deuxième partie 6. Ici (visible sur la figure 10), la première partie 5A s'étend au niveau de la paroi latérale 55 de la cavité 50 tandis que la deuxième partie 6 s'étend au niveau de la paroi de fond 52 de la cavité 50.

De manière avantageuse selon l'invention, la première partie 5A présente une première épaisseur e₁ et la deuxième partie 6 présente une deuxième épaisseur e₂. Dans la présente invention, on définit l'épaisseur d'une partie d'une couche comme la distance séparant les deux faces de la partie de la couche concernée. En d'autres termes, l'épaisseur correspond à la dimension caractéristique de la couche concernée dans une direction parallèle à une direction normale aux faces de la partie concernée de la couche.

Ici, la première épaisseur e₁ et la deuxième épaisseur e₂ sont distinctes. Autrement dit, la couche de matériau ferroélectrique 5 présente une épaisseur non-uniforme. En d'autres termes encore, la couche de matériau ferroélectrique 5 présente une épaisseur variable.

Les différences d'épaisseurs forment des caractéristiques primordiales du dispositif de stockage ferroélectrique pour obtenir les différents états de polarisation.

Ainsi, grâce à l'invention, les différences d'épaisseurs utilisées pour la couche de matériau ferroélectrique introduisent une non-uniformité dans les propriétés ferroélectriques de la couche de matériau ferroélectrique. Cette non-uniformité des propriétés permet notamment d'augmenter les différences entre les gammes de tensions à appliquer pour encoder les informations dans les différents états de polarisation intermédiaires. Cela permet alors d'éviter le recouvrement entre les gammes de tensions concernées et donc d'identifier sans ambiguïté les états de polarisation intermédiaires concernés par les informations mémorisées.

Afin d'obtenir des états de polarisation bien distincts (i.e. sans recouvrement entre les gammes de tensions à appliquer pour les atteindre), le rapport entre la deuxième épaisseur e₂ et la première épaisseur e₁ est de préférence compris entre 2 et 4.

En pratique, la première épaisseur e₁ est par exemple comprise entre 3 et 7 nm. De préférence, cette première épaisseur e₁ est de l'ordre de 4 nm.

La deuxième épaisseur e₂ est par exemple comprise entre 8 et 17 nm. De préférence, cette deuxième épaisseur e₂ est de l'ordre de 10 nm.

Ici, la deuxième épaisseur e₂ est donc supérieure à la première épaisseur e₁. Cela implique alors qu'il sera nécessaire d'appliquer une plus forte tension pour permettre l'encodage des informations mémorisées dans l'état de polarisation intermédiaire associé à la deuxième épaisseur e₂ (en comparaison de la première épaisseur e₁).

Les gammes d'épaisseurs considérées dans l'invention permettent d'accentuer les non-uniformités des propriétés ferroélectriques de la couche de matériau ferroélectrique, de manière à permettre la mémorisation des informations sur différents états de polarisation intermédiaires et à permettre l'encodage de ces informations en distinguant distinctement ces différents états.

Plus particulièrement ici, comme cela est représenté sur la figure 2, la deuxième partie 6 de la couche de matériau ferroélectrique 5 comprend une première portion 6A et une deuxième portion 6B.

La première portion 6A s'étend, au niveau de la paroi de fond 52 de la cavité 50, dans le prolongement de la première partie 5A de la couche de matériau ferroélectrique 5. Cette première portion 6A présente par exemple ici la même épaisseur e₁ que la première partie 5A de la couche de matériau ferroélectrique 5.

Comme visible sur la figure 2, la deuxième portion 6B s'étend en saillie depuis la première portion 6A de la couche de matériau ferroélectrique 5. En d'autres termes, la deuxième portion 6B forme une protubérance de matériau ferroélectrique sur la première portion 6A de la couche de matériau ferroélectrique 5.

Ici, la deuxième portion 6B présente ici une forme (en coupe) trapézoïdale, avec une surface de contact 6C avec la première portion 6A de plus petite dimension que la surface 6D opposée (libre). Comme cela est visible sur la figure 2, la deuxième portion 6B est agencée de manière à ce que cette surface 6D libre, correspondant à une extrémité libre de la deuxième portion 6B, est positionnée plus près de la deuxième couche 7 que de la première couche 2.

De manière avantageuse selon l'invention, la surface de contact 6C représente, horizontalement (dans un plan parallèle à la paroi de fond 52 de la cavité 50), au moins 75% de la surface totale S de la deuxième partie 6 de la couche de matériau ferroélectrique 5. Comme cela est visible sur la figure 2, la surface totale S de la deuxième partie 6 de la couche 5 de matériau ferroélectrique correspond à la surface (horizontale) de la première portion 6A d'épaisseur e₁.

Ainsi, avantageusement selon l'invention, les non-uniformités (associées aux différences d'épaisseurs) de la couche de matériau ferroélectrique ne sont pas des artefacts de fabrication. Le fait que les parties associées aux différentes épaisseurs présentent des surfaces conséquentes permet de s'assurer d'états de polarisation bien distincts (et donc d'une absence de recouvrement entre les gammes de tensions à appliquer pour remonter aux différents états de polarisation).

Comme le montre la figure 2, le dispositif 1 de stockage ferroélectrique comprend également la deuxième couche 7. Cette deuxième couche 7 est disposée sur la couche de matériau ferroélectrique 5. La première partie 5A et la deuxième partie 6 sont donc positionnées entre la première couche 2 et la deuxième couche 7.

Cette deuxième couche 7 comprend par exemple un matériau conducteur. Il s'agit notamment d'un matériau métallique.

Selon un premier exemple (non représenté), la deuxième couche comprend une unique couche. Le matériau conducteur de cette unique couche comprend par exemple du nitrure de titane TiN. En variante, le matériau conducteur peut être du nitrure de tantale TaN ou du tungstène W. En variante encore, d'autres matériaux conducteurs peuvent être utilisés (et en particulier, du nitrure de métal de manière plus générale).

Comme cela est visible sur la figure 2, la deuxième couche 7 se présente ici sous la forme d'une structure bicouche. Elle comprend ici une première sous-couche 70 et une deuxième sous-couche 72.

La deuxième sous-couche 72 de la deuxième couche 7 est disposée sur la première sous-couche 70 associée.

La deuxième sous-couche 72 est formée d'un matériau conducteur comprenant un métal de transition. Ce matériau conducteur est par exemple du nitrure de titane TiN. En variante, il peut s'agir d'autres matériaux conducteurs tels que du nitrure de tantale TaN ou du tungstène W.

La deuxième sous-couche 72 présente une épaisseur comprise entre 10 et 200 nm.

Cette deuxième sous-couche 72 joue à la fois le rôle d'une couche de protection, et le rôle d'une couche de contact permettant de raccorder électriquement le dispositif 1 à son circuit électronique de pilotage et de lecture.

La première sous-couche 70 est disposée sur la couche de matériau ferroélectrique 5. Elle est en contact direct avec la couche de matériau ferroélectrique 5. En d'autres termes, la première sous-couche 70 de la deuxième couche 7 s'étend entre la deuxième sous-couche 72 et la couche de matériau ferroélectrique 5.

La deuxième sous-couche 72 comprend un matériau conducteur métallique. De préférence, elle comprend du titane Ti ou du tantale Ta.

Par exemple, lorsque la deuxième sous-couche 72 comprend du nitrure de titane, la première sous-couche 70 est formée d'un matériau conducteur comme le titane Ti.

En variante, lorsque la deuxième sous-couche 72 comprend du nitrure de tantale, la première sous-couche 70 est formée d'un matériau conducteur comme le tantale Ta.

En variante encore, lorsque la deuxième sous-couche 72 comprend du tungstène, la première sous-couche 70 est formée d'un matériau conducteur choisi parmi le titane Ti ou le tantale Ta.

Ici, l'épaisseur de la première sous-couche 70 est comprise entre 3 et 20 nm.

En pratique, dans le cas d'une mémoire de type OxRAM (pour « *Oxide Resistive RAM*»), lorsque cette structure bicouche est utilisée pour la deuxième couche 7, la première sous-couche 70 présente également la particularité d'être une couche qui va permettre la création de lacunes d'oxygène dans la couche de matériau ferroélectrique 5 (lorsque cette première sous-couche 70 est en contact avec la couche de matériau ferroélectrique 5). Dans ce cas, la première sous-couche 70 comprend un matériau conducteur choisi parmi le titane Ti ou le tantale Ta et la deuxième sous-couche 72 comprend un nitrure de titane TiN ou un nitrure de tantale TaN (de manière à former une couche de protection). La création de ces lacunes d'oxygène permet alors d'améliorer les performances du dispositif de stockage ferroélectrique en facilitant les échanges d'oxygène avec la couche de matériau ferroélectrique.

Dans le cas d'une mémoire de type FeRAM, la deuxième couche 7 comprend par exemple un nitrure métallique ou un métal qui ne s'oxyde pas (tel que la tungstène W ou le ruthénium Ru).

Dans le cas d'une mémoire de type FTJ, la structure utilisée est celle d'une mémoire de type FeRAM avec l'introduction d'une couche comprenant un matériau diélectrique entre la couche de matériau ferroélectrique 5 et la deuxième couche 7. Le matériau diélectrique est par exemple un oxyde diélectrique tel que l'oxyde d'aluminium Al₂O₃ ou le dioxyde de silicium SiO₂.

En variante, la deuxième couche peut comprendre un matériau semi-conducteur. Ce matériau semi-conducteur comprend par exemple du silicium.

De manière avantageuse selon l'invention, le dispositif de stockage ferroélectrique comprend une couche de matériau ferroélectrique dont l'épaisseur est variable. Cette variabilité d'épaisseur entraîne une non-uniformité dans les propriétés ferroélectriques du dispositif de stockage ferroélectrique. Cette non-uniformité des propriétés permet notamment d'augmenter les différences entre les gammes de tensions à appliquer pour encoder les informations dans les différents états de polarisation intermédiaires.

En d'autres termes, grâce à la non-uniformité créée dans la couche de matériau ferroélectrique (due à la variabilité d'épaisseurs), des différences entre les états de polarisation intermédiaires sont créées.

En variante, la couche de matériau ferroélectrique peut comprendre plus de deux épaisseurs distinctes. Il peut notamment s'agir d'une variation continue de l'épaisseur.

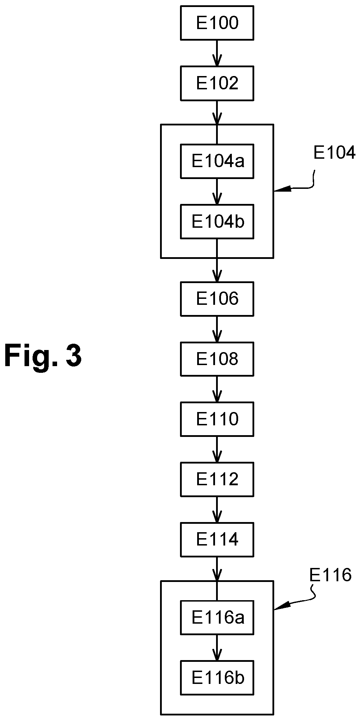

La présente invention concerne également un procédé de fabrication d'un dispositif 1 de stockage ferroélectrique. Les figures 3 à 11 concernent ce procédé de fabrication.

La figure 3 représente, sous forme de logigramme, un exemple du procédé de fabrication selon un exemple de réalisation.

Comme cela est visible sur cette figure, le procédé de fabrication comprend tout d'abord une étape E100 de fourniture d'une couche support 10 sur laquelle va être formé le dispositif 1 de stockage ferroélectrique. En pratique, cette couche support 10 est munie d'au moins un composant logique associé à un élément d'interconnexion métallique (non représentés) destinés à connecter le dispositif 1 de stockage ferroélectrique à des niveaux métalliques inférieurs.

Puis, le procédé de fabrication se poursuit à l'étape E102, lors que laquelle la cavité 50 (dans laquelle va être formé le dispositif 1 de stockage ferroélectrique) est formée. La figure 4 illustre cette étape E102.

En pratique, cette étape E102 est mise en oeuvre par une gravure anisotrope de manière à former la paroi de fond 52 et la paroi latérale 55 de la cavité 50. Il s'agit par exemple ici d'une gravure chimique sèche.

Comme décrit précédemment, la paroi latérale 55 de la cavité 50 est réalisée de telle manière à former l'angle d'inclinaison α par rapport à l'axe z parallèle à une direction normale à la paroi de fond 52. La paroi latérale 55 forme donc un angle d'inclinaison α non nul par rapport à un axe z, correspondant à une direction normale à la paroi de fond 52.

Comme cela est visible sur la figure 3, le procédé de fabrication se poursuit, à l'étape E104, par le dépôt de la première couche 2. La figure 5 illustre cette étape E104.

Cette première couche 2 est déposée dans la cavité 50. Plus particulièrement, la première couche 2 est déposée le long de la paroi de fond 52 et de la paroi latérale 55 de la cavité 50. La première couche 2 tapisse et épouse donc la forme de la cavité 50.

Le dépôt de la première couche 2 est effectué ici de manière conforme. Dans cette description, on entend par « dépôt conforme » un dépôt mis en oeuvre de telle façon que la couche présente une épaisseur sensiblement constante en tout point. Dans cette description, on entend par « sensiblement constante », une épaisseur ne variant pas de plus de 20 %, de préférence de plus de 10 %, et de préférence encore de plus de 5%. Par exemple, la première couche 2 peut être formée par une méthode de dépôt par couche atomique (ou ALD pour « *Atomic Layer Deposition* » selon l'acronyme d'origine anglo-saxonne couramment utilisé).

Comme indiqué précédemment, la première couche 2 comprend ici une première sous-couche 20 et une deuxième sous-couche 22.

L'étape E104 de dépôt de la première couche 2 comprend donc ici deux sous-étapes : une première sous-étape E104a de dépôt de la première sous-couche 20 et une deuxième sous-étape E104b de dépôt de la deuxième sous-couche 22.

La première sous-couche 20 est donc tout d'abord déposée, de manière conforme, dans la cavité 50 (étape E104a). En pratique, la première sous-couche 20 est par exemple formée par une méthode de dépôt par couche atomique (ou ALD) ou par dépôt chimique en phase vapeur.

En variante, la première sous-couche 20 peut être formée par pulvérisation cathodique dans une chambre de dépôt sous vide. Dans le cas où la première sous-couche 20 est formée en nitrure de titane, il s'agit d'une pulvérisation cathodique réactive.

Puis, la deuxième sous-couche 22 de la première couche 2 est déposée, de manière conforme, sur la première sous-couche 20 (étape E104b). La deuxième sous-couche 22 est par exemple formée par pulvérisation cathodique dans une chambre de dépôt sous vide. En pratique, la deuxième sous-couche 22 de la première couche 2 est formée dans la même chambre de dépôt que la première sous-couche 20 de la première couche 2.

Dans le cas où la deuxième sous-couche 22 est formée en nitrure de titane, il s'agit d'une pulvérisation cathodique réactive.

Puis, le procédé de fabrication se poursuit à l'étape E106 de dépôt d'une première couche de matériau ferroélectrique 15A sur la première couche 2. Plus particulièrement, la première couche de matériau ferroélectrique 15A est déposée sur la deuxième sous-couche 22 de la première couche 2. Cette étape E106 est représentée sur la figure 6.

Il s'agit ici d'un dépôt conforme de la première couche de matériau ferroélectrique 15A sur la première couche 2.

Ici, l'étape E106 de dépôt est par exemple mise en oeuvre de telle façon que la première couche de matériau ferroélectrique 15A présente une épaisseur e₁.

En pratique, la première couche de matériau ferroélectrique 15A est déposée par une méthode de dépôt par couche atomique (ou ALD).

En variante, la première couche de matériau ferroélectrique peut être déposée par pulvérisation cathodique. En variante encore, la première couche de matériau ferroélectrique peut être déposée par une méthode de dépôt physique en phase vapeur (ou PVD pour « *Physical Vapor Deposition* »). En variante encore, la première couche de matériau ferroélectrique peut être déposée par une méthode de dépôt par faisceau d'ions (ou IBD pour « *Ion Beam Deposition* »).

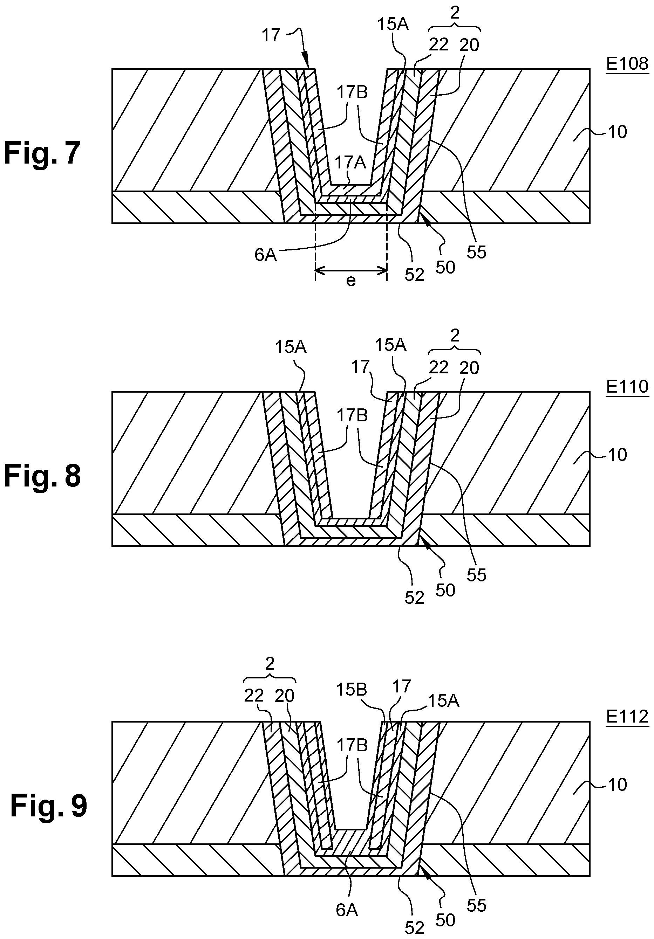

Le procédé se poursuit ensuite, à l'étape E108, par le dépôt d'une couche intermédiaire 17. Cette couche intermédiaire 17 est formée sur la première couche de matériau ferroélectrique 15A. Cette étape E108 est représentée sur la figure 7.

Il s'agit ici d'un dépôt conforme de la couche intermédiaire 17 sur la première couche de matériau ferroélectrique 15A. La couche intermédiaire 17 est donc déposée de manière uniforme (sur la première couche de matériau ferroélectrique 15A) le long de la paroi latérale 55 et de la paroi de fond 52 de la cavité 50.

Comme le montre la figure 7, la couche intermédiaire 17 comprend une première partie 17A s'étendant le long de la paroi de fond 52 de la cavité 50 et une deuxième partie 17B s'étendant le long de la paroi latérale 55 de la cavité 50.

La couche intermédiaire 17 comprend par exemple ici un nitrure ou un oxyde. Il s'agit par exemple ici de nitrure de silicium SiN ou de carbonitrure de silicium SiCN. En variante, la couche intermédiaire peut comprendre du dioxyde de silicium SiO₂.

En pratique, la couche intermédiaire 17 est déposée par une méthode de dépôt par couche atomique (ou ALD).

En variante, la couche intermédiaire peut être déposée par pulvérisation cathodique. En variante encore, la couche intermédiaire peut être déposée par une méthode de dépôt physique en phase vapeur (ou PVD pour « *Physical Vapor Deposition* »). En variante encore, la couche intermédiaire peut être déposée par une méthode de dépôt par faisceau d'ions (ou IBD pour « *Ion Beam Deposition* »).

En variante encore, la couche intermédiaire peut être formée selon un dépôt non conforme.

L'épaisseur de la couche intermédiaire 17 est par exemple associée à la largeur l (illustrée sur la figure 7) de la première portion 6A de la première couche de matériau ferroélectrique 15A. Plus particulièrement, l'épaisseur de la couche intermédiaire 17 est ici inférieure à 10% de la largeur l de la première portion 6A. De préférence, l'épaisseur de la couche intermédiaire 17 est inférieure à 7,5% de la largeur l de la première portion 6A.

Comme le montre la figure 3, le procédé se poursuit par une étape E110 de retrait de la première partie 17A horizontale de la couche intermédiaire 17 de sorte à exposer une partie de la première couche de matériau ferroélectrique 15A. Cette étape E110 est représentée sur la figure 8.

Plus particulièrement ici, l'étape E110 de retrait vise à retirer la partie de la couche intermédiaire 17 déposée au niveau de la paroi de fond 52 de la cavité 50. La partie de la première couche de matériau ferroélectrique 15A exposée est donc située au niveau de la paroi de fond 52. En d'autres termes, à l'issue de l'étape E110 de retrait, la couche intermédiaire 17 comprend une partie restante présente au niveau de la paroi latérale 55. Cette partie restante correspond à la deuxième partie 17B de la couche intermédiaire 17 introduite précédemment.

En pratique, cette étape E110 de retrait est mise en oeuvre par une gravure anisotrope. Cette gravure anisotrope permet donc de retirer uniquement la première partie 17A de la couche intermédiaire 17.

Cette gravure anisotrope est par exemple une gravure au plasma. En variante, la gravure anisotrope peut être une gravure ionique réactive (ou RIE pour « *Reactive Ion Etching* » selon l'acronyme d'origine anglosaxonne couramment utilisé).

A l'issue de l'étape E110, le long de la paroi de fond 52, la première portion 6A de la première couche de matériau ferroélectrique 15A est donc mise à nu. En d'autres termes, à l'issue de l'étape E110, le long de la paroi de fond 52 de la cavité 50, la première couche de matériau ferroélectrique 15A est la dernière couche déposée. Par ailleurs, le long de la paroi latérale 55 de la cavité, la couche intermédiaire 17 (et plus particulièrement la deuxième partie 17B de la couche intermédiaire 17) est la dernière couche formée.

Le procédé de fabrication comprend ensuite une étape E112 de dépôt d'une deuxième couche de matériau ferroélectrique 15B. Plus particulièrement, cette deuxième couche de matériau ferroélectrique 15B est formée sur la deuxième partie 17B de la couche intermédiaire 17 et sur partie exposée de la première couche de matériau ferroélectrique 15A. Autrement dit, la deuxième couche de matériau ferroélectrique 15B est formée sur la deuxième partie 17B de la couche intermédiaire 17 et sur la première portion 6A de la première couche de matériau ferroélectrique 15A formée au niveau de la paroi de fond 52. Cette étape E112 est représentée sur la figure 9.

Il s'agit ici d'un dépôt conforme de la deuxième couche de matériau ferroélectrique 15B sur la deuxième partie 17B de la couche intermédiaire 17 et sur la première portion 6A de la première couche de matériau ferroélectrique 15A.

Ici, l'étape E112 de dépôt est par exemple mise en oeuvre de telle façon que la deuxième couche de matériau ferroélectrique 15B présente une épaisseur e₃. Cette épaisseur e₃ est telle que, au niveau de la paroi de fond 52 de la cavité 50, l'épaisseur totale de matériau ferroélectrique est de l'ordre de la deuxième épaisseur e₂.

En pratique, la deuxième couche de matériau ferroélectrique 15B est déposée par une méthode de dépôt par couche atomique (ou ALD pour « *Atomic Layer Deposition* » selon l'acronyme d'origine anglo-saxonne couramment utilisé).

En variante, la deuxième couche de matériau ferroélectrique peut être déposée par pulvérisation cathodique. En variante encore, la deuxième couche de matériau ferroélectrique peut être déposée par une méthode de dépôt physique en phase vapeur (ou PVD pour « *Physical Vapor Déposition* »). En variante encore, la deuxième couche de matériau ferroélectrique peut être déposée par une méthode de dépôt par faisceau d'ions (ou IBD pour « *Ion Beam Deposition* »).

La deuxième couche de matériau ferroélectrique est par exemple ici formée du même matériau que la première couche de matériau ferroélectrique.

Comme cela est visible sur la figure 9, la couche intermédiaire 17 joue le rôle « d'espaceur » entre la première couche de matériau ferroélectrique 15A et la deuxième couche de matériau ferroélectrique 15B.

Comme cela est visible sur la figure 3, le procédé de fabrication se poursuit par une étape E114 (représentée sur la figure 10). Lors de cette étape, la deuxième partie 17B de la couche intermédiaire 17 est retirée de l'empilement.

Cette étape vise spécifiquement à retirer la partie restante de la couche intermédiaire 17. Comme lors de l'étape E112 décrite précédemment, la deuxième couche de matériau ferroélectrique 15B a été déposée en partie sur la deuxième partie 17B de la couche intermédiaire 17, l'étape E114 de retrait de cette deuxième partie 17B de la couche intermédiaire 17 entraîne également le retrait de cette partie de la deuxième couche de matériau ferroélectrique 15B positionnée sur la deuxième partie 17B de la couche intermédiaire 17.

En d'autres termes, lors de cette étape E114 de retrait, tout ce qui se trouve au-dessus de la deuxième partie 17B de la couche intermédiaire 17 est retiré en même temps que cette deuxième partie 17B.

En pratique, cette étape E114 de retrait est mise en oeuvre par gravure isotrope. Il s'agit par exemple ici d'une gravure chimique humide. Cette gravure est par exemple mise en oeuvre avec de l'acide orthophosphorique chaud.

Ainsi, à l'issue de l'étape E114, la couche intermédiaire 17 a été complètement retirée de l'empilement. En ce qui concerne le matériau ferroélectrique, une unique couche de matériau ferroélectrique 5 est formée à partir de la première couche de matériau ferroélectrique 15A et de la partie de la deuxième couche de matériau ferroélectrique 15B déposée au niveau de la paroi de fond 52 de la cavité 50. La partie de la première couche de matériau ferroélectrique 15A s'étendant le long de la paroi latérale 55 de la cavité 50 correspond à la première partie 5A du dispositif 1 de stockage ferroélectrique introduite précédemment. La première portion 6A de la première couche de matériau ferroélectrique 15A s'étendant le long de la paroi de fond 52 de la cavité ainsi que la partie de la deuxième couche de matériau ferroélectrique 15B déposée au niveau de la paroi de fond 52 de la cavité 50 forment, elles, la deuxième partie 6 du dispositif 1 de stockage ferroélectrique introduite précédemment.

Cette étape E114 correspond en fait à un processus dit de « *lift-off* » qui vise à retirer spécifiquement la deuxième partie 17B de la couche intermédiaire 17 de manière à obtenir une forme spécifique pour la couche de matériau ferroélectrique 5 obtenue (ici avec une portion en saillie formée sur la première portion 6A de la première couche de matériau ferroélectrique 15A). La couche intermédiaire 17 forme donc ici une couche sacrificielle qui permet, grâce au procédé de fabrication selon l'invention, d'obtenir une couche de matériau ferroélectrique avec une forme voulue et une épaisseur variable en utilisant uniquement (dans ce procédé de fabrication) des dépôts conformes pour les différentes couches impliquées.

Par ailleurs, la condition sur l'épaisseur de la couche intermédiaire mentionnée précédemment permet d'assurer des surfaces conséquentes associées à chaque partie de la couche de matériau ferroélectrique d'épaisseur différentes. Cela permet alors de s'assurer d'états de polarisation bien distincts (et donc d'une absence de recouvrement entre les gammes de tensions à appliquer pour remonter aux différents états de polarisation).

Comme cela est représenté sur la figure 3, le procédé de fabrication se termine par l'étape E116. Lors de cette étape, illustrée sur la figure 11, la deuxième couche 7 est formée.

La deuxième couche 7 est formée sur la couche de matériau ferroélectrique 5 obtenue à l'issue de l'étape E114.

Le dépôt de la deuxième couche 7 est ici réalisé de manière conforme.

Comme indiqué précédemment, la deuxième couche 7 peut comprendre ici une première sous-couche 70 et une deuxième sous-couche 72.

L'étape E116 de dépôt de la deuxième couche 7 comprend donc ici deux sous-étapes : une première sous-étape E116a de dépôt de la première sous-couche 70 et une deuxième sous-étape 116b de dépôt de la deuxième sous-couche 72.

La première sous-couche 70 est donc tout d'abord déposée, de manière conforme, sur la couche de matériau ferroélectrique 5 (étape E116a). En pratique, la première sous-couche 70 est par exemple formée par pulvérisation cathodique dans une chambre de dépôt sous vide. Dans le cas où la première sous-couche 70 est formée en nitrure de titane, il s'agit d'une pulvérisation cathodique réactive.

En variante, la première sous-couche peut être formée par un dépôt chimique en phase vapeur.

Puis, la deuxième sous-couche 72 de la deuxième couche 7 est déposée, de manière conforme, sur la première sous-couche 70 (étape E116b). Comme cela est visible sur la figure 11, la deuxième sous-couche 72 est formée de manière à remplir tout l'espace restant dans la cavité 50. Cela permet alors d'obtenir un dispositif de stockage ferroélectrique 1 complètement intégré dans la cavité 50 et sans saillie ou récession formée par rapport à la surface de la couche support 10. L'ensemble formé par la couche support 10 dans laquelle est intégrée le dispositif de stockage ferroélectrique 1 présente donc une surface uniforme.

En pratique, la deuxième sous-couche 72 est par exemple formée par pulvérisation cathodique dans une chambre de dépôt sous vide. En pratique, la deuxième sous-couche 72 de la deuxième couche 7 est formée dans la même chambre de dépôt que la première sous-couche 70 de la deuxième couche 7.

Dans le cas où la deuxième sous-couche 72 est formée en nitrure de titane, il s'agit d'une pulvérisation cathodique réactive.

En pratique, en bien que cela ne soit pas visible sur les figures annexées, il n'est pas exclu que les différentes couches du dispositif 1 de stockage ferroélectrique soient déposées également sur la face avant (surface libre à l'opposé de la paroi de fond 52) de la couche support 10. Ainsi, de manière optionnelle, afin de s'assurer de la planéité et de l'uniformité du dispositif 1 de stockage ferroélectrique (et en particulier de la surface libre du dispositif 1), il peut être prévu une étape de planarisation, après l'étape E116. Cette étape de planarisation est par exemple mise en oeuvre par polissage mécanochimique (ou CMP pour « *Chemical mechanical polishing* » selon l'acronyme d'origine anglosaxonne couramment utilisé). Tout autre méthode adaptée peut être utilisée (notamment les méthodes de masquage).

Cette étape de planarisation est particulièrement avantageuse car, grâce à l'uniformisation de la surface du dispositif 1, elle permet d'améliorer les performances électriques du dispositif de stockage ferroélectrique et de garantir une meilleure qualité des interconnexions.

En variante, une étape d'encapsulation peut être prévue après cette étape de planarisation. Enfin, un raccordement à la deuxième couche 7 peut être mis en oeuvre.

Ainsi, à l'issue du procédé de fabrication, le dispositif de stockage ferroélectrique 1 obtenu comprend une couche de matériau ferroélectrique à épaisseur variable. Comme indiqué précédemment, la variabilité d'épaisseurs permet d'introduire des non-uniformités dans les propriétés ferroélectriques de la couche de matériau ferroélectrique. Cette non-uniformité des propriétés permet notamment d'augmenter les différences entre les gammes de tensions à appliquer pour encoder les informations dans les différents états de polarisation intermédiaires.

Cela permet alors d'éviter le recouvrement entre les gammes de tensions concernées et donc d'identifier sans ambiguïté les états de polarisation intermédiaires concernés par les informations mémorisées.

De plus, le procédé de fabrication selon l'invention permet d'obtenir une architecture du dispositif 1 de stockage ferroélectrique en trois dimensions. Cela permet notamment d'augmenter la surface de la capacité du dispositif 1 de stockage ferroélectrique.

Le procédé de fabrication proposé selon l'invention est particulièrement simple à mettre en oeuvre car il ne fait intervenir que des dépôts conformes pour former chacune des couches formant le dispositif 1 de stockage ferroélectrique.

Selon une variante de mise en oeuvre de ce mode de réalisation, le procédé de fabrication peut comprendre, entre l'étape E106 de dépôt de la première couche de matériau ferroélectrique et l'étape E108 de dépôt de la couche intermédiaire, une étape d'implantation d'un élément dopant dans la première couche de matériau ferroélectrique formée à l'étape E106. Cette étape permet alors de doper la couche de matériau ferroélectrique par l'élément dopant.

En pratique, l'étape d'implantation est par exemple mise en oeuvre dans un réacteur différent de la chambre de dépôt de la première couche et de la première couche de matériau ferroélectrique.

Ici, il s'agit par exemple d'une étape d'implantation ionique du silicium (qui est l'élément dopant) dans la couche de matériau ferroélectrique. Les doses d'implantation sont par exemple comprises entre 1.10¹⁴ cm⁻² et 1.10¹⁵ cm⁻². De préférence, la dose d'implantation est comprise entre 0,3.10¹⁵ cm⁻² et 1.10¹⁵ cm⁻².

Selon une autre variante de réalisation, le procédé de fabrication peut également comprendre, après l'étape E114 de retrait de la deuxième partie de la couche intermédiaire et avant l'étape de dépôt de la deuxième couche, une étape d'implantation d'un élément dopant dans la deuxième portion 6B de la couche de matériau ferroélectrique (obtenue à l'issue de l'étape E114). Cette étape permet alors de doper la deuxième portion 6B de la couche de matériau ferroélectrique par l'élément dopant.

Ici, il s'agit par exemple d'une étape d'implantation ionique du silicium (qui est l'élément dopant) dans la deuxième portion 6B de la couche de matériau ferroélectrique. Les doses d'implantation sont par exemple comprises entre 1.10¹⁴ cm⁻² et 1.10¹⁵ cm⁻². De préférence, la dose d'implantation est comprise entre 0,3.10¹⁵ cm⁻² et 1.10¹⁵ cm⁻².

Ainsi, en variante, la couche de matériau ferroélectrique peut être complètement ou seulement en partie dopée par l'élément dopant.

### Applications

Le dispositif de stockage ferroélectrique conforme à l'invention trouve une application privilégiée dans le cadre des mémoires résistives de type FeRAM (pour « *Ferroelectric Random Access Memory* » selon l'acronyme d'origine anglo-saxonne couramment utilisé).

Il trouve également une application particulière dans le cadre de transistors, par exemple de type FeMFET (pour « *Ferroelectric-metal field effect transistor* » selon l'acronyme d'origine anglo-saxonne couramment utilisé).

Le dispositif de stockage ferroélectrique conforme à l'invention peut également être utilisé dans le cadre de jonctions tunnel ferroélectriques (ou FTJ pour « *Ferroelectric tunnel jonction* » selon l'acronyme d'origine anglosaxonne couramment utilisé). Dans ce cas, une couche supplémentaire est ajoutée entre la couche de matériau ferroélectrique et la deuxième couche. Cette couche supplémentaire comprend un matériau diélectrique. Ce matériau diélectrique est par exemple un oxyde d'aluminium Al₂O₃.

Dans le cas de certaines applications mentionnées (par exemple les mémoires de type FeRAM ou de type FTJ), la première couche forme une première électrode (par exemple une électrode inférieure), la deuxième couche forme une deuxième électrode (par exemple une électrode supérieure) et la couche de matériau ferroélectrique forme une couche mémoire.

## Revendications

1. Procédé de fabrication d'un dispositif (1) de stockage ferroélectrique comprenant des étapes de :
- fourniture d'une couche support (10),
- dépôt d'une première couche (2),
- dépôt d'une première couche de matériau ferroélectrique (15A), puis
- dépôt d'une couche intermédiaire (17) sur la première couche de matériau ferroélectrique (15A), puis
- retrait d'une première partie (17A) de la couche intermédiaire (17) de sorte à exposer une partie (6A) de la première couche de matériau ferroélectrique (15A), puis
- dépôt d'une deuxième couche de matériau ferroélectrique (15B) sur la couche intermédiaire (17) et sur la partie (6A) exposée de la première couche de matériau ferroélectrique (15A), puis
- retrait d'une deuxième partie (17B) de la couche intermédiaire (17) de manière à former, à partir de la première couche de matériau ferroélectrique (15A) et d'une portion de la deuxième couche de matériau ferroélectrique (15B), une couche de matériau ferroélectrique (5) comprenant une première partie (5A) présentant une première épaisseur (e₁) et une deuxième partie (6) présentant une deuxième épaisseur (e₂), la première épaisseur (e₁) et la deuxième épaisseur (e₂) étant distinctes, et
- dépôt d'une deuxième couche (7), la couche de matériau ferroélectrique (5) s'étendant entre la première couche (2) et la deuxième couche (7).

2. Procédé de fabrication selon la revendication 1, dans lequel le dépôt de la première couche de matériau ferroélectrique (15A) est mis en oeuvre de manière conforme.

3. Procédé de fabrication selon la revendication 1 ou 2, dans lequel le dépôt de la couche intermédiaire (17) est mis en oeuvre de manière conforme.

4. Procédé de fabrication selon l'une quelconque des revendications 1 à 3, dans lequel la couche intermédiaire (17) comprend un nitrure ou un oxyde.

5. Procédé de fabrication selon l'une quelconque des revendications 1 à 4, dans lequel l'étape de retrait de la première partie (17A) de la couche intermédiaire (17) est mise en oeuvre par une gravure anisotrope.

6. Procédé de fabrication selon l'une quelconque des revendications 1 à 5, dans lequel le dépôt de la deuxième couche de matériau ferroélectrique (15B) est mis en oeuvre de manière conforme.

7. Procédé de fabrication selon l'une quelconque des revendications 1 à 6, dans lequel l'étape de retrait de la deuxième partie (17B) de la couche intermédiaire (17) est mise en oeuvre par une gravure isotrope.

8. Procédé de fabrication selon l'une quelconque des revendications 1 à 7, dans lequel la couche de matériau ferroélectrique (5) comprend du dioxyde d'hafnium ou du dioxyde d'hafnium dopé par un élément dopant ou un alliage HfₓZr₁₋ₓO₂, avec 0<x<1 .

9. Procédé de fabrication selon l'une quelconque des revendications 1 à 8, dans lequel il est prévu, avant l'étape de dépôt de la première couche (2), une étape de formation d'une cavité (50) dans la couche support (10), la cavité (50) comprenant une paroi de fond (52) et une paroi latérale (55), la paroi latérale (55) formant un angle d'inclinaison (α) par rapport à une direction normale à la paroi de fond (52),
le dépôt de la première couche (2), de la couche de matériau ferroélectrique (5 ) et de la deuxième couche (7) étant mis en oeuvre dans la cavité (50) formée, la deuxième partie (6) de la couche de matériau ferroélectrique (5) étant positionnée sur la paroi de fond (52) de la cavité (5) et la première partie (5A) de la couche de matériau ferroélectrique (5) étant positionnée sur la paroi latérale (55) de la cavité (50).

10. Dispositif (1) de stockage ferroélectrique comprenant une première couche (2), une deuxième couche (7) et une couche de matériau ferroélectrique (5) qui s'étend entre la première couche (2) et la deuxième couche (7), le dispositif (1) comprenant une couche support (10) présentant une cavité (50), la cavité (50) comprenant une paroi de fond (52) et une paroi latérale (55), la paroi latérale (55) formant un angle d'inclinaison (α) par rapport à une direction normale à la paroi de fond (52),
la première couche (2), la couche de matériau ferroélectrique (5) et la deuxième couche (7) étant positionnées dans la cavité (50),
la couche de matériau ferroélectrique (5) comprenant une première partie (5A) présentant une première épaisseur (e₁) et une deuxième partie (6) présentant une deuxième épaisseur (e₂), la première épaisseur (e₁) et la deuxième épaisseur (e₂) étant distinctes, la première partie (5A) et la deuxième partie (6) de la couche de matériau ferroélectrique (5) étant positionnées entre la première couche (2) et la deuxième couche (7),
la deuxième partie (6) de la couche de matériau ferroélectrique (5) comprenant une première portion (6A) s'étendant dans le prolongement de la première partie (5A) et une deuxième portion (6B) s'étendant en saillie par rapport à la première portion (6A) de la deuxième partie (6) de la couche de matériau ferroélectrique (5), la deuxième portion (6B) étant agencée de manière à ce qu'une extrémité libre (6D) de cette deuxième portion (6B) est positionnée plus près de la deuxième couche (7) que de la première couche (2).
